# EUROPEAN PATENT APPLICATION

(11) **EP 0 585 086 A2**
(43) Date of publication of application: **02.03.1994**
(21) Application number: 93306633.4
(22) Date of filing: 20.08.1993
(51) Int. Cl.: G01R 31/28, G06F 11/24

(54) **Method and apparatus for self-testing of delay faults**

(30) Priority: 27.08.1992 US 935717
(71) Applicant: AT&T Corp., New York, NY 10013-2412 (US)
(72) Inventor: Aadsen, Duane Rodney, Bath, Pennsylvania 18014 (US); Scholz, Harold Norman, Allentown, Pennsylvania 18103 (US); Zorian, Yervant, Princeton, New Jersey 08540 (US)
(74) Representative: Buckley, Christopher Simon Thirsk

(57) **Abstract**

A method is provided for enabling a digital circuit (12), clocked by a series of pulses, to test itself for delay faults. The method uses delay cells (16,24,36,30,32) to detect delay faults within the digital circuit. A pattern generator (14) supplies a test pattern to the digital circuit. Delay cells (16) within the pattern generator are used to detect delay faults associated with two or more inputs. The circuit response is captured and evaluated for correctness. The delay cells are used to capture the response at the correct time to detect delay faults between input(s) and output(s). Two methods are shown - one that depends on the clock period and one that does not.

## Description

### Technical Field

This invention relates to a technique for enabling an electronic circuit to test itself for a delay fault associated with a signal being unable to propagate through the circuit within a prescribed time.

### Background of the Invention

There is a trend among the manufacturers of digital circuits to provide circuits that can operate at ever higher speeds. The circuit operating speed is usually defined in terms of the frequency (rate) of clock pulses applied to the circuit to cause it to step through its operating states. Today, digital circuits are available that operate at speeds in excess of 100 MHz. As the operating speed of digital circuits increases, the problem of delay faults, that is, the failure of a signal to propagate from the circuit input to its output within the interval between successive clock pulses, becomes more pronounced. Therefore, customers of high-speed digital circuits often demand that such circuits be tested before purchase to avoid reliability problems associated with delay faults.

Presently, there is really no satisfactory way to do an in-circuit test specifically for delay faults in digital circuits. Rather, delay faults are detected, if at all, as a consequence of functionally testing the device by applying one or more patterns of functional test vectors to the digital circuit, while operating the circuit at its rated speed. Following receipt of the test vector pattern, the circuit will generate a response that is then compared to an expected response to determine if the circuit is operating properly. A failure of one or more vectors to propagate from the input of the digital circuit to its output within the interval between clock pulses should cause the actual circuit response to the test vectors to differ from the expected response.

Traditionally, the testing of digital circuits in this manner to detect delay faults has required the use of stand-alone test sets that can test the circuits at their rated operating speed. As the operating speed of digital circuits has increased, so too has the cost and complexity of test sets, making testing an expensive procedure. For this reason, some manufacturers have chosen not to test their circuits at their rated operating speed to uncover delay faults. Even those manufacturers who perform at-speed functional testing may not detect all delay faults as a consequence of inadequate fault coverage.

Thus, there is a need for a technique to detect delay faults which overcomes the above-mentioned disadvantages.

### Summary of the Invention

Briefly, in accordance with the invention, a method is provided for enabling a digital circuit, clocked by a series of pulses, to test itself for delay faults as recited in claim 1.

### Brief Description of the Drawing

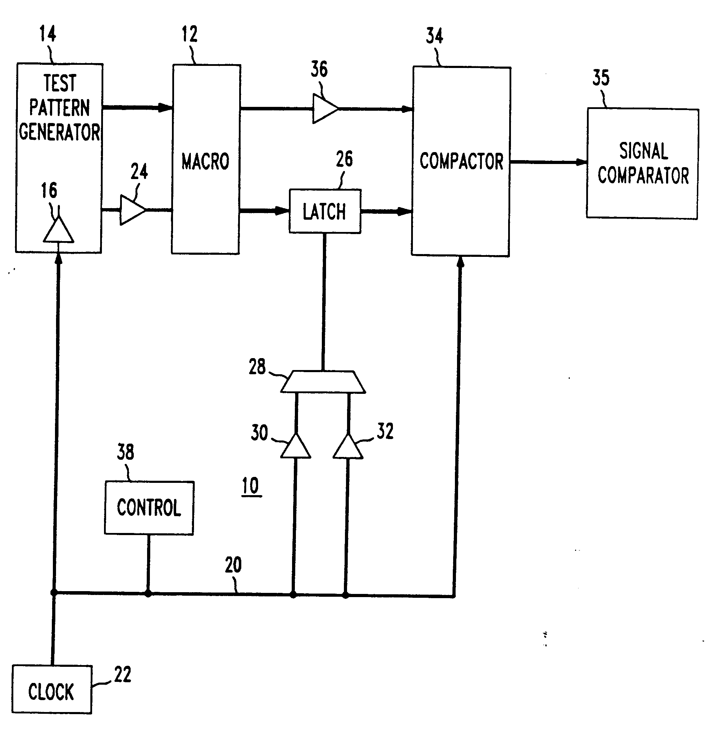

FIGURE 1 is a block schematic diagram of a system in accordance with the invention for detecting faults associated with the delay of signals propagating through an electronic circuit.

### Detailed Description

FIGURE 1 is a block schematic diagram of a system 10 in accordance with the invention for detecting delay faults associated with signals propagating through a circuit 12, which may take the form of a macrocell block, such as a Random Access Memory (RAM), a Read Only Memory (ROM), or an Application Specific Integrated Circuit (ASIC). For this reason, the block 12 bears the legend "macro." Alternatively, the circuit 12 may take the form of a combination of sequential and/or combinational circuits.

The delay fault detection system 10 comprises a test pattern generator 14 for generating a test pattern supplied to the macro 12. As an example, for a RAM, the test pattern generator 14 may be configured with a macro enable generator (not shown), a read/write control generator (not shown), a macro enable generator (not shown), an address generator (not shown) for providing address information, and an input data generator (not shown) for providing data information. Associated with the test pattern generator 14 are delay gates 16 and 24 for delaying the receipt of the test patterns.

In addition to the test pattern generator 14, the delay fault detection system 10 of the invention generally includes one or more latch(es) 26 (only a single one of which has been shown). When a test pattern from the test pattern generator 14 is applied to the macro 12, the macro responds by generating a response signal which is latched in the latch 26. The latch 26 is clocked by a clock signal generated at the output of a multiplexer 28 having one or more inputs (two being shown in FIG. 1), which are supplied with a clock signal from the bus 20 through one or more separate delay gates, two such gates 30 and 32 shown in FIG. 1. Typically, the delay gates 30 and 32 have separate delay values, each associated with a separate type of delay fault to be detected. For example, the propagation time from address-to-data outputs (checked by delay gate 30) and the macro-enable-to-data outputs (checked by delay gate 32) represents different delay faults in a RAM.

The latch 26, which serves to hold the response signal from the macro 12, is coupled to a compactor 34 which serves to compact (i.e., logically combine) successive patterns supplied from the latch so as to yield a single pattern (signature) indicative of the presence of a delay fault, if any. In practice, the compactor 34 is typically configured of a linear feedback shift register. Associated with the compactor 34 is a comparison circuit 35 which serves to compare the signature generated by the compactor after compaction of the successive response signals with a signature indicative of a fault-free condition. Additional set(s) of latch(es) 26, multiplexer 28, and gate delays 30 and 32 may be duplicated for different outputs of macro 12.

Overall control of the system 10 is carried out by a control unit 38 comprised of a finite state machine that controls and initializes the test pattern generator 14, the compactor 34, and the multiplexer 28. To test for an overall delay fault, the controller 38 enables the test pattern generator 14 to supply a test pattern to the macro 12 upon the receipt of a clock signal, as delayed by the delay gate 16. As mentioned previously, following receipt of the test pattern, the macro 12 generates a response pattern which is latched in the latch 26 upon receipt of the clock signal, as delayed by a selected one of the delay gates 30 and 32.

The overall delay imposed by a separate one of the delay gates 30 and 32 is chosen to be a function of the delay of the test pattern generator 14 (including delay gate(s) 16 and delay gate(s) 24), the delay of the macro 12, the delay of the controller 38, as well as overall delay of the system 10. In practice, the delay imposed by the pattern generator 14, plus the normal delay of the macro 12 and the controller 38, equals the delay on gates 30 and/or 32 plus the multiplexer 28 delay, plus the setup time for latch(es) 26. Under normal conditions (i.e., no delay faults), the response pattern generated by the macro 12 should be latched in the latch 26 within the interval between clock signals. The delay on gates 30 and/or 32 and the pattern generator setup time define the minimum interval between successive active clock edges for the simplest mode of operation. With extra logic, the controller 38 could be made to run the macro 12 every second (or third etc.) clock cycle to allow for very high frequency clocks.

However, in the event that the macro 12 suffers from a delay fault, then the increase in the overall delay incurred by the macro is such that macro 12's response to the test pattern from the test pattern generator 14 fails to become latched in the latch 26 within the interval between clock pulses. As a consequence, the signal supplied from the latch 26 to the compactor 34 differs from the expected signal.

The pattern supplied from the latch 26 is compacted by the compactor 34 with the previously supplied pattern. If any test pattern supplied to the compactor 34 differs from the expected pattern, then the compacted signature produced by the compactor 34 will differ from the expected signature, as determined by the comparison circuit 35. Thus, by comparing the signature actually produced by the compactor 34 to a reference signature representative of a no-delay fault condition, the comparison circuit 35 can detect a delay fault.

In some instances, the delay associated with a single one of the outputs of the macro 12 is of interest, rather than the delay associated with an entire pattern. As indicated, each delay gate 36 associated with a particular output of the macro 12 serves to delay the signal produced at that output prior to receipt by the compactor 34. The overall delay imposed by delay gate 36 is chosen to be a function of the delay of the test pattern generator 14 (including delay gate(s) 16 and delay gate(s) 24), the delay of the macro 12, the delay of the controller 38, the delay through the compactor 34, and the delay interval between successive active edges of the clock. In practice, the delay on gate 36 equals the delay interval between successive active edges of the clock minus the combined delays of the test pattern generator 14, the macro 12, the controller 38, and the setup time of the compactor 34. In the event of a delay fault associated with such an output of the macro 12, the signature ultimately produced by the compactor 34 will differ from its expected signature. Thus, by observing the signature of the compactor 34, a delay fault associated with one or more selected outputs of the macro 12 can be detected by the comparison circuit 35. This method requires a periodic clock.

The testing of delay faults between inputs of the macro 12 is carried out in much the same manner as that described above. The delay gate 24 associated with the input of interest will delay the receipt of a test signal from the test pattern generator 14 to that input by an interval greater than the overall delay associated with the test pattern input to the macro 12. If the particular input associated with the delay gate 24 has a delay in excess of a prescribed value, then the response appearing at one or more individual macro outputs will be different from the expected value. Under these conditions, the signature ultimately generated by the compactor 34 will differ from its expected signature, as determined by the comparison circuit, indicating the presence of a delay fault. For example, in an asynchronous RAM, the setup time of the address with respect to the write is checked by delaying the write with delay 24 such that the address arrives exactly at the setup time before the write.

The testing of delay faults between inputs may require delaying multiple signals with the same interval. This may be accomplished with multiple delay gates 24, or by adding a delay gate 16 internal to the test pattern generator. For example, to test the hold time of the address with respect to the write in an asynchronous RAM, the entire address bus must be delayed by the hold time more than the write. This can be accomplished by adding gate 16 or multiple delay gates 24. This method of detecting input delay faults is independent of the clock period as long as the time between clock pulses is greater than a period defined by the BIST control 38, test pattern generator 14, macro 12, delay gates 30 and 32, and the compactor 34.

Three distinct methods for detecting delay faults have been presented. One method uses delay gates 30 and 32, multiplexer 28 and latch 26 to detect propagation delay faults between input(s) and output(s). This method is independent of the timing of clock pulses as long as the pulses maintain a minimum spacing.

The second method that consists of delay gate 36 also detects delay faults between input(s) and output(s), but requires a periodic clock of known period. The third method, consisting of delay gates 16 and/or 24, detects delay faults between inputs such as setup or hold times. This method has the same minimum spacing of clock pulses as the first method. An advantage of the first and third methods is that delay faults can be detected without a constant period clock of known frequency. As long as clock pulses obey a minimum time between pulses, delay faults will be detected.

A distinct advantage of the above-described system 10 for testing delay faults is that the system can be readily implemented with the macro 12 in a single structure. In the case where the macro 12 is implemented in silicon, or a similar semiconductor material, the test pattern generator 14, compactor 34, comparison circuit 35, as well as the various delay gates 16, 24, 30, 32 and 36 can also be implemented in the same piece of silicon. By the same token, when the macro 12 comprises a plurality of discrete devices affixed to a circuit board (not shown), the system 10 will be configured of discrete devices affixed to the same board. The combination of the system 10 and the macro 12 affords the macro the opportunity to effectively test itself for delay faults.

It is to be understood that the above-described embodiments are merely illustrative of the principles of the invention. Various modifications and changes may be made thereto by those skilled in the art which will embody the principles of the invention and fall within the spirit and scope thereof.

## Claims

1. A method for testing a circuit (12), clocked by clock pulses, to detect delay faults, CHARACTERIZED BY the steps of:
(a) launching a first test signal into the circuit following a first predetermined interval to cause the circuit to generate a response signal upon receipt of the test signal;
(b) collecting the circuit response signal after a predetermined interval; and
(c) comparing the signal at the signal-collecting means after receipt of a successive clock signal to determine if the signal corresponds to the first test signal launched into the circuit.

2. The method according to claim 1 CHARACTERIZED IN THAT:
(a) each of a plurality of first test signals is successively launched into the circuit (12) after a first delay interval;
(b) collecting the circuit response signal after a second predetermined interval;
(c) each successive signal received at the signal-collecting means is compacted with each successively generated response signal to yield a signature for comparison to a reference signature representing a fault-free condition.

3. Apparatus for detecting delay faults in a circuit (12) clocked by clock signals, CHARACTERIZED BY:
test pattern generator means (14) for launching a first test signal into the circuit to cause the circuit to generate a response;
first delay gate means (16) associated with the test pattern generator means for delaying the receipt of the test pattern by the circuit by a first predetermined interval;
signal-collecting means (26,34) for collecting the response signal generated by the circuit following receipt of the first test signal and for providing an indication of a delay fault;
second delay means (28,30,32) for delaying the receipt of the response signal at the signal-collecting means by a second predetermined interval; and
comparison means (35) for comparing the signal at the collecting means with a reference signal indicative of a fault-free condition.

4. The apparatus according to claim 3 wherein the signal-collecting means IS CHARACTERIZED BY:
a latch (26) for latching the response signal generated by the circuit; and
a compactor (34) for compacting successive signals received from the latch.

5. The apparatus according to claim 3 CHARACTERIZED IN THAT the second delay means includes at least one delay gate (30) for delaying receipt of a clock signal by the latch to delay the receipt thereby of the response signal from the circuit.

6. The apparatus according to claim 3 CHARACTERIZED IN THAT the second delay means includes a plurality of individual delay gates (30,32), a selected one of which serves to delay receipt of a clock signal by the latch to delay the receipt thereby of the response signal by the latch.

7. The apparatus according to claim 3 CHARACTERIZED IN THAT the signal-collecting means comprises a compactor (34) and wherein the second delay means comprises a delay gate (36) for delaying receipt by the compactor of the response signal from the circuit.

8. The apparatus according to claim 3 CHARACTERIZED BY a delay means (24) for delaying receipt of a test signal from the test pattern generator means to the circuit by an interval different from the first predetermined interval.
